## Europäisches Patentamt

## European Patent Office

## Office européen des brevets

(19)

(11) Numéro de publication : **0 022 015**

**B1**

(12)

# FASCICULE DE BREVET EUROPÉEN

(45) Date de publication du fascicule du brevet :
03.08.83

(21) Numéro de dépôt : **80400939.7**

(22) Date de dépôt : **24.06.80**

(51) Int. Cl.³ : **H 03 F 1/02**, H 03 F 3/21

(54) **Dispositif amplificateur et procédé d'amplification pour audio-fréquences.**

(30) Priorité : **27.06.79 FR 7916558**

(43) Date de publication de la demande :
**07.01.81 Bulletin 81/01**

(45) Mention de la délivrance du brevet :
**03.08.83 Bulletin 83/31**

(84) Etats contractants désignés :
**DE GB IT**

(56) Documents cités :
**DE A 1 960 841**
**DE A 2 304 162**
**DE A 2 705 604**

(73) Titulaire : **THOMSON-CSF**
**173, Boulevard Haussmann**
**F-75379 Paris Cedex 08 (FR)**

(72) Inventeur : **Moreau, Jean-Michel**
**"THOMSON-CSF" SCPI 173, bld Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

Jouve, 18, rue St-Denis, 75001 Paris, France

## Dispositif amplificateur et procédé d'amplification pour audio-fréquences

La présente invention concerne un dispositif amplificateur de puissance pour audio-fréquences.

Les circuits amplificateurs de puissance pour audio-fréquences permettent habituellement de débiter sur une charge des puissances électriques importantes. Une des caractéristiques principales de tels amplificateurs est le rendement, c'est-à-dire le rapport entre la puissance effectivement débitée sur la charge et la puissance totale fournie par la source d'alimentation qui les alimente. Une seconde caractéristique importante est la tension maximale qu'ils peuvent fournir sur la charge pour une tension d'alimentation donnée. En outre, il est manifestement intéressant d'un point de vue économique de disposer d'un amplificateur ne nécessitant qu'une seule source de tension d'alimentation.

Un certain nombre de dispositifs connus ont permis de réaliser des amplificateurs ayant de bonnes caractéristiques en ce qui concerne l'un ou l'autre des points précédemment cités. Parmi ces dispositifs connus, l'amplificateur classe B a un rendement relativement élevé, voisin de 0,8 dans le cas d'amplification d'un signal sinusoïdal d'amplitude voisine du maximum admissible. Cet amplificateur, bien connu dans la technique, a une borne de sortie pouvant débiter un courant bi-directionnel et dont le potentiel peut varier entre zéro et la tension maximale de la source d'alimentation. La charge est généralement connectée d'une part à la borne de sortie de l'amplificateur et d'autre part à un point de potentiel intermédiaire, ce potentiel étant le plus souvent équidistant du potentiel zéro et du potentiel maximal V de la source d'alimentation. La tension aux bornes de la charge peut alors varier entre − V/2 et + V/2, et généralement sa valeur moyenne est nulle. Dans ces conditions, le point de potentiel intermédiaire peut être obtenu en connectant un condensateur de forte valeur entre le point de potentiel zéro ou le point de potentiel + V et la borne de la charge opposée à la borne de sortie de l'amplificateur. Pour les parties du signal supérieures à la valeur moyenne, la source d'alimentation fournit à la charge le courant nécessaire sortant de la borne de sortie de l'amplificateur, fournissant ainsi une charge au condensateur. Pour les parties du signal inférieures à la valeur moyenne, le condensateur fournit à la charge le courant nécessaire, ce courant entrant par la borne de sortie de l'amplificateur. Ce type d'amplificateur de puissance a un bon rendement lorsque le signal de sortie a une valeur proche de la valeur maximale. Par contre, lorsqu'on utilise un tel amplificateur pour amplifier des signaux de plus faible valeur, son rendement décroît rapidement, étant par exemple voisin de 0,4 lorsque la puissance est égale au quart de la puissance maximale de sortie admissible.

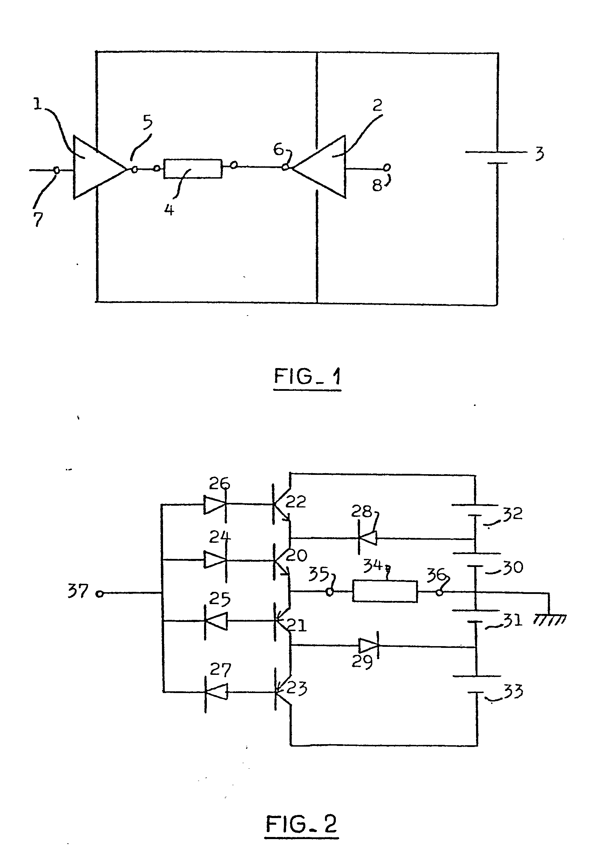

Un autre dispositif connu, représenté schématiquement en figure 1, consiste à connecter deux amplificateurs classe B 1 et 2, alimentés par la même source d'alimentation 3, la charge 4 étant connectée entre les deux bornes de sortie 5 et 6 des amplificateurs. La borne d'entrée 7 de l'amplificateur 1 reçoit le signal à amplifier, alors que la borne d'entrée 8 de l'amplificateur 2 reçoit l'opposé de ce signal. Cette disposition a un rendement identique à celui d'un amplificateur classe B unique, mais permet en outre d'obtenir sur la charge une tension comprise entre + V et − V, V étant la tension de la source d'alimentation unique 3.

Un autre dispositif connu, du même type que celui décrit dans le document DE-A-2 304 162, est représenté schématiquement à la figure 2. Ce dispositif, connu sous le nom d'amplificateur classe G, comprend deux amplificateurs en classe B imbriqués et alimentés par des tensions d'alimentation différentes. Les transistors 20 et 21 forment un premier amplificateur en classe B, alimenté par l'intermédiaire des diodes 28 et 29 par la source d'alimentation à point milieu formée par les sources de tension 30 et 31 connectées en série. La charge 34, étant connectée entre la borne de sortie 35 de cet amplificateur et le point milieu 36 des sources, est soumise à une tension de sortie qui peut varier entre + V et − V, V étant la tension aux bornes des sources de tension 30 ou 31. En supposant que les transistors 20 et/ou 21 sont saturés, des transistors 22 et 23, connectés en série avec ceux-ci de la façon représentée sur la figure, forment un deuxième amplificateur en classe B, alimenté par la source à point milieu formée par les sources de tension en série 30, 31, 32 et 33. On utilise généralement des sources 32 et 33 avant la même tension V'. Lorsque ce deuxième amplificateur est en fonctionnement, la tension aux bornes de la charge 34, toujours connectée entre la borne de sortie 35 de l'amplificateur et le point milieu 36 des sources, est soumise à une tension pouvant varier de − (V + V') à + (V + V'). Les diodes 24, 25, 26 et 27 connectées aux bases des transistors 20, 21, 22 et 23 forment un ensemble de communication permettant de commander soit le premier amplificateur, soit le second amplificateur suivant le niveau de la tension d'entrée appliquée à la borne d'entrée 37. Cette disposition permet, lorsque le signal d'entrée sur la borne 37 est faible, de commander uniquement le premier amplificateur en classe B constitué par les transistors 20 et 21. Cet amplificateur, alimenté par les sources de tension 30 et 31, fonctionne dans de meilleures conditions que s'il était alimenté par la source de tension maximale formée par 30, 31, 32 et 33. Ainsi, son rendement est supérieur à celui qui serait obtenu par un amplificateur en classe B seul alimenté par la tension maximale. De même, lorsque la tension d'entrée sur la borne 37 est grande, la tension de sortie aux bornes de la charge 34 devant dépasser la valeur V des sources 30 et 31, le deuxième amplificateur formé par les transistors 22 et 23 est alors commandé. Il permet d'amplifier les parties de signal correspondant à des tensions de sortie supérieures à V, et pouvant aller jusqu'à V + V'. Le second amplificateur travaille alors également dans de bonnes conditions, puisque sa tension de sortie est voisine de la tension maximale admissible. L'amplificateur en classe G ainsi décrit a un rendement supérieur au rendement d'un amplificateur en classe B, ou de deux amplificateurs en pont tels que décrits à la figure 1. Néanmoins, il ne permet pas de fournir sur la charge une tension crête supérieure à la moitié de la tension maximale d'alimentation formée par la somme des tensions des sources 30, 31, 32 et 33, et en outre il nécessite la présence de plusieurs sources d'alimentation de puissance.

La présente invention vise notamment à réaliser des amplificateurs de puissance pour audio-fréquence ayant un rendement aussi bon que celui des amplificateurs classe G en réduisant le nombre des sources d'alimentation de puissance nécessaires.

De même, la présente invention vise à réaliser des amplificateurs présentant les avantages du dispositif de l'art antérieur décrit à la figure 1, c'est-à-dire d'une part ne nécessitant qu'une seule source d'alimentation de puissance de tension V, fournissant sur la charge une tension crête égale à + V, et présentant l'avantage d'un bon rendement tel que celui de l'amplificateur en classe G de la figure 2.

Pour atteindre ces objets ainsi que d'autres, la présente invention prévoit un dispositif amplificateur pour audio-fréquences, comprenant un premier et un second amplificateurs, le premier amplificateur étant alimenté par une source d'alimentation de tension V1 dont les deux bornes de sortie sont à des potentiels symétriques par rapport à une borne de potentiel zéro, ledit dispositif amplificateur débitant sur une charge comportant des première et seconde bornes, la première borne étant reliée à la borne de sortie du premier amplificateur, le second amplificateur étant alimenté par une tension d'alimentation V2 dont les bornes sont à des potentiels symétriques par rapport à la borne de potentiel zéro, ce dispositif comprenant aussi des moyens de commutation à deux états et des moyens de commande pour forcer les moyens de commutation dans l'un ou l'autre de leurs états suivant le niveau du signal à amplifier par le dispositif amplificateur, les moyens de commutation connectant dans le premier état la deuxième borne de la charge à la borne de sortie du second amplificateur et dans le deuxième état la deuxième borne de la charge à la borne de potentiel zéro et comprenant en outre des moyens de transmission pour appliquer au second amplificateur un signal d'entrée fonction du signal à amplifier dès que ce signal a atteint et dépassé un niveau amenant le premier amplificateur à la saturation.

Selon un autre aspect de la présente invention, le second amplificateur est également alimenté par la source d'alimentation V1, la source d'alimentation V2 étant supprimée. L'ensemble ne comporte ainsi qu'une seule source d'alimentation de puissance.

Selon un autre aspect de la présente invention, la borne de potentiel zéro est connectée à une borne d'un condensateur de forte valeur, l'autre borne de ce condensateur étant connectée à l'une des bornes de la source d'alimentation.

Selon un autre aspect de la présente invention, le dispositif de commande est tel qu'il provoque la connexion de la charge à la borne de potentiel zéro lorsque le signal d'entrée est inférieur au seuil prédéterminé correspondant à la saturation du premier amplificateur, et la connexion de la charge à la borne de sortie du second amplificateur lorsque le signal d'entrée est supérieur audit seuil.

Selon un autre aspect de la présente invention, les moyens de commutation comprennent au moins un transistor à effet de champ, connecté entre la charge et la borne de potentiel zéro.

Selon un autre aspect de la présente invention, les moyens pour appliquer au second amplificateur un signal d'entrée comprennent un inverseur dont l'entrée est connectée à la borne d'entrée du dispositif amplificateur, et dont la borne de sortie est connectée à l'une des deux entrées d'un dispositif additionneur produisant sur sa borne de sortie connectée à l'entrée du deuxième amplificateur un signal égal à la somme des signaux appliqués sur ces deux entrées. La seconde entrée du dispositif additionneur est connectée à la sortie du premier amplificateur par l'intermédiaire d'un pont diviseur de résistances de rapport 1/G, G étant le gain de ce premier amplificateur.

Ces objets, caractéristiques et avantages ainsi que d'autres de la présente invention seront exposés plus en détail dans la description suivante de modes de réalisation particuliers, faite en relation avec les figures jointes parmi lesquelles :

la figure 1   est destinée à illustrer un dispositif de l'art antérieur ;

la figure 2   représente un autre dispositif de l'art antérieur ;

la figure 3   représente schématiquement un mode de réalisation particulier du dispositif selon l'invention ;

la figure 4   représente un autre mode de réalisation d'un dispositif selon l'invention ; et

la figure 5   représente de façon plus détaillée le dispositif selon le mode de réalisation de la figure 4.

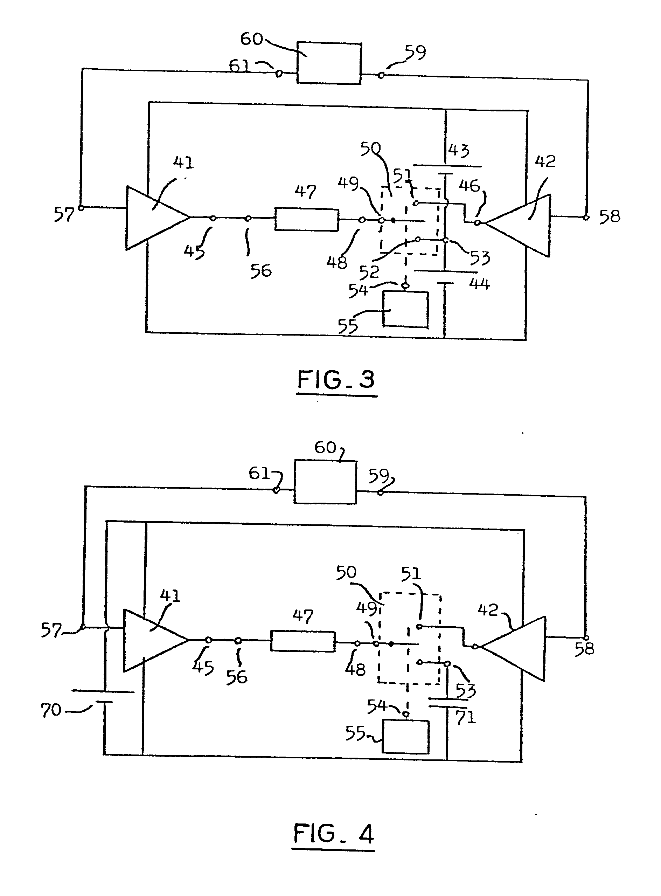

Comme cela est représenté schématiquement à la figure 3, le dispositif amplificateur selon la présente invention comprend deux amplificateurs 41 et 42 alimentés par une source d'alimentation formée par les sources de tension 43 et 44 de tension égale V connectées en série. Chacun des deux amplificateurs 41 et 42 est capable de fournir sur sa borne de sortie, respectivement 45 et 46, un potentiel pouvant varier entre le potentiel le plus négatif et le potentiel le plus positif de la source d'alimentation 43-44, et admettant un courant de sortie dans les deux sens. La borne de sortie 45 de l'amplificateur 41 est connectée à une borne 56 de la charge 47. La seconde borne 48 de la charge est connectée à une borne de sortie 49 d'un sous-ensemble de commutation 50. Ce dispositif de commutation comporte deux autres bornes de sortie, la borne 51 qui est connectée à la borne de sortie 46 de l'amplificateur 42, et la borne 52 qui est connectée à la borne 53, point commun des sources d'alimentation 43 et 44. La borne 53 est appelée borne de potentiel zéro. Le sous-ensemble de commutation 50 est commandé par l'intermédiaire d'une liaison représentée en pointillés 54 par un sous-ensemble de commande 55. Le sous-ensemble de commutation 50 remplit la fonction d'un interrupteur inverseur, pouvant se situer notamment dans les deux états suivants : dans l'état I la borne 49 est connectée électriquement à la borne 51, la borne 52 étant isolée des bornes 49 et 51 ; dans l'état II la borne 49 est connectée à la borne 52, la borne 51 étant isolée des bornes 49 et 52. La borne d'entrée 57 de l'amplificateur 41 reçoit le signal à amplifier. La borne d'entrée 58 de l'amplificateur 42 est connectée à la borne de sortie 59 d'un sous-ensemble de transmission 60 dont une borne d'entrée 61 est connectée à la borne d'entrée 57 de l'amplificateur 41.

Le fonctionnement du dispositif est le suivant :

Lorsque le sous-ensemble de commutation 50 est en position I, la charge 47 est soumise à la différence des tensions de sortie des amplificateurs 41 et 42. Cette tension aux bornes de la charge peut donc prendre toute valeur comprise entre + 2 V et − 2 V. Lorsque l'un des amplificateurs est saturé, par exemple lorsque l'amplificateur 41 a sa borne de sortie 45 au potentiel maximum, la tension aux bornes de la charge 47 ne dépend plus que de la tension de sortie de l'amplificateur 42. Cette tension est alors fonction du signal d'entrée présent à la borne 57 qui est transmis par l'intermédiaire de l'élément de transmission 60 à la borne d'entrée de l'amplificateur 42.

Lorsque le sous-ensemble de commutation est en position II, la charge est connectée entre la sortie de l'amplificateur 41 et la borne 53 de potentiel zéro. Il faut remarquer que la source d'alimentation formée par les deux sources de tension 43 et 44 en série a ses deux bornes de sortie à des potentiels symétriques par rapport à la borne 53 de potentiel zéro. Dans cette position II du dispositif de commutation 50, la tension aux bornes de la charge 47 ne dépend que de la tension de sortie de l'amplificateur 41. Cette tension peut donc prendre toute valeur comprise entre + V et − V. Le dispositif amplificateur se comporte alors comme un amplificateur en classe B.

Il est prévu, selon une caractéristique de la présente invention, d'utiliser ce dispositif de la manière suivante : lorsque le signal d'entrée sur la borne 57 a une valeur faible, c'est-à-dire de module inférieur à un certain seuil correspondant à la saturation de l'amplificateur 41, le sous-ensemble de commande 55 force le dispositif de commutation 50 dans l'état II. L'amplificateur 41 fournit alors seul le courant nécessaire à la charge 47, l'amplificateur 42 n'étant parcouru par aucun courant de charge et dissipant donc une puissance négligeable. Par contre, lorsque le signal présent à la borne d'entrée 57 est supérieur au seuil de saturation de l'amplificateur 41, le sous-ensemble de commande 55 force le dispositif de commutation 50 dans l'état I, mettant ainsi en fonctionnement le deuxième amplificateur 42. Pendant tout le temps où le signal à l'entrée reste supérieur au seuil de saturation, l'amplificateur 41 reste saturé, sa borne de sortie 45 étant à un potentiel fixe voisin du potentiel de l'une des deux bornes extrêmes de la source d'alimentation. Cet amplificateur 41 est parcouru par le courant traversant la charge, mais étant donné son état de saturation, la puissance qu'il dissipe est très faible. L'ensemble de transmission 60 et l'amplificateur 42, sous l'action du signal d'entrée à la borne 57, fournissent sur la charge 47 le complément de tension correspondant à la partie du signal d'entrée qui dépasse le seuil de saturation de l'amplificateur 41. Pour cela, le sous-ensemble de transmission 60 fournit à sa borne de sortie 59 un signal égal à la différence entre d'une part le signal d'entrée présent à la borne 57 et d'autre part la tension d'entrée qui suffit à provoquer la saturation de l'amplificateur 41. Cette différence, appliquée avec un signe convenable à l'entrée de l'amplificateur 42, permet d'obtenir sur la borne de sortie 46 dudit amplificateur la tension complémentaire à la tension déjà fournie par la borne de sortie 45 de l'amplificateur 41 en état de saturation. Lorsqu'un signal variable est appliqué à l'entrée 57, le sous-ensemble 55 de commande réagit de façon à forcer la commutation du dispositif 50 chaque fois que la valeur absolue du signal d'entrée dépasse ou devient inférieure à la tension de seuil de saturation de l'amplificateur 41.

Le dispositif ainsi utilisé permet d'obtenir les avantages suivants : d'une part, la tension maximale possible sur la charge 47 est égale à 2 V ; d'autre part, dans les deux modes d'utilisation, c'est-à-dire lorsque l'amplificateur 41 fonctionne seul ou lorsque les deux amplificateurs 41 et 42 fonctionnent ensemble, la puissance dissipée au niveau de ces amplificateurs est égale à la puissance que dissiperait un amplificateur en classe B dont la tension d'alimentation est égale à 2 V lorsque le signal d'entrée est faible et est égale à 4 V lorsque le signal d'entrée est grand. Cela conduit à utiliser ces amplificateurs en classe B dans des conditions qui leur sont plus favorables au point de vue rendement, c'est-à-dire dans des conditions où la tension de sortie est la plus proche de la tension maximale admissible. De même, on peut considérer que ce dispositif permet de réaliser un amplificateur audiofréquence ayant les mêmes caractéristiques de rendement qu'un amplificateur en classe G à quatre sources d'alimentation tel que décrit à la figure 2.

La figure 4 reprend les principaux éléments du dispositif représentés en figure 3, et représente un mode de réalisation particulier d'un dispositif amplificateur selon l'invention. Comme cela est représenté sur la figure, selon ce mode de réalisation, le dispositif ne comprend qu'une seule source d'alimentation 70 alimentant les deux amplificateurs 41 et 42. Dans ce cas, la borne 53 de potentiel zéro est connectée à l'une des bornes de sortie de la source d'alimentation 70 par l'intermédiaire d'un condensateur 71 de forte valeur. On a représenté sur la figure une connexion de ce condensateur à la borne négative de la source d'alimentation. Ce mode de réalisation est satisfaisant pour les applications où la tension aux bornes de la charge doit avoir une valeur moyenne nulle. En effet, pendant les alternances positives, le condensateur se charge dans un certain sens, et pendant les alternances négatives, le condensateur se décharge de la même valeur dans l'autre sens la valeur de sa tension n'ayant pas le temps de varier de façon sensible. On a ainsi réalisé un dispositif amplificateur selon l'invention ne comportant qu'une seule source d'alimentation au lieu de deux sources pour le mode de réalisation précédent, et de quatre sources pour les réalisations connues telles que représentées à la figure 2.

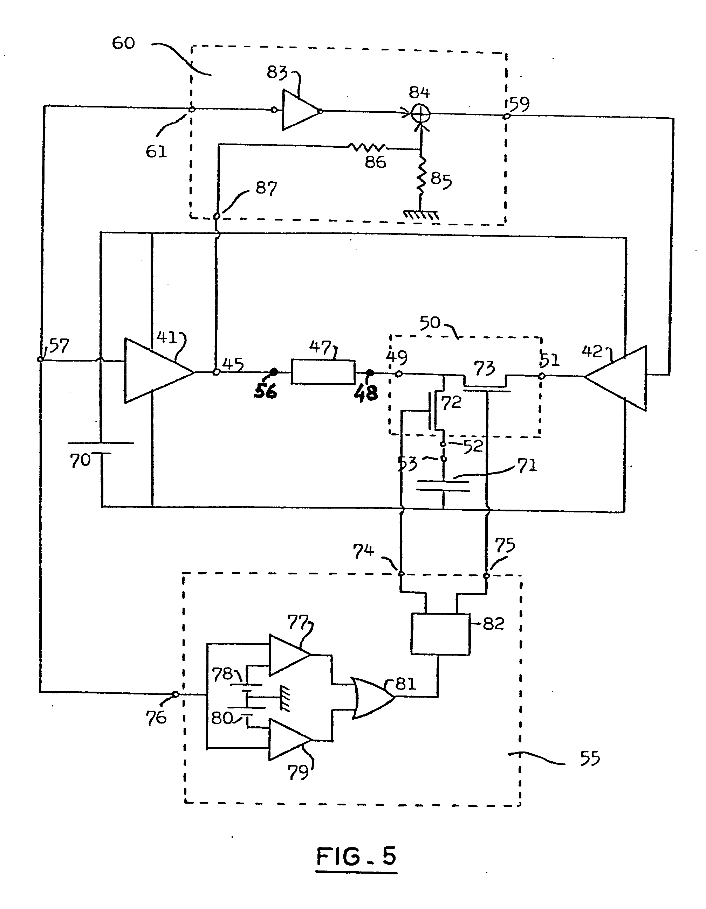

La figure 5 reprend les principaux éléments représentés en figure 4 avec la même disposition de connexion électrique et fournit une représentation plus détaillée des sous-ensembles de commande 55 et de transmission 60. L'amplificateur 41 est connecté par sa sortie 45 à la charge 47, une autre borne de la charge étant connectée à la borne 49 du dispositif de commutation 50, la sortie de l'amplificateur 42 étant connectée à une autre borne 51 de ce même dispositif de commutation 50. La borne de potentiel zéro 53 est connectée à une autre borne de sortie 52 du dispositif 50. Selon ce mode de réalisation, ce dispositif 50 comprend deux transistors à effet de champ 72 et 73 de type MOS connectés de la façon suivante : le transistor 72 a son drain connecté à la borne de sortie 52, sa source connectée à la borne de sortie 49 du dispositif de commutation 50, et sa grille connectée à une borne de sortie 74 du sous-ensemble de commande 55. Le transistor 73 a sa source connectée à la borne de sortie 51, son drain connecté à la borne de sortie 49 du dispositif de commutation, et sa grille connectée à une borne de sortie 75 du sous-ensemble de commande 55. Ces deux connexions de grille aboutissant aux bornes 74 et 75 du dispositif de commande sont un mode de réalisation de la liaison, figurée par les pointillés 54 de la figure 3, entre le dispositif de commutation 50 et le sous-ensemble de commande 55.

Le sous-ensemble de commande 55, selon ce mode de réalisation, comprend une borne d'entrée 76 connectée à la borne d'entrée 57 du dispositif d'amplification. Un comparateur 77 a une première borne d'entrée connectée à la borne d'entrée 76, une seconde borne d'entrée connectée à la borne positive d'une source de tension 78 dont la borne négative est connectée à la masse, et une borne de sortie connectée à une première borne d'entrée d'une porte logique ou 81. Un second comparateur 79 a une borne d'entrée connectée à la borne d'entrée 76, une autre borne d'entrée connectée à la borne négative d'une source de tension 80 dont la borne positive est connectée à un point de potentiel zéro, et une borne de sortie connectée à l'autre borne d'entrée de la porte logique 81. La borne de sortie de la porte OU 81 est connectée à la borne d'entrée d'un dispositif amplificateur 82. Ce dispositif 82 a deux bornes de sortie connectées respectivement à la borne de sortie 74 et à la borne 75 du sous-ensemble de commande 55. Le dispositif 82 est réalisé par tout moyen bien connu dans la technique pour commander deux transistors à effet de champ de type MOS à partir d'une tension d'entrée fournie par la porte logique 81. Les sources de tension 78 et 80 sont de valeur égale, cette valeur correspondant au seuil de saturation de l'amplificateur 41, c'est-à-dire à la tension qui, appliquée à la borne 57, provoque la saturation de cet amplificateur.

Ces sources de tension 78 et 80 sont des sources de référence de faible puissance réalisées dans la pratique par tout moyen bien connu dans la technique, par exemple par dérivation aux bornes de la source d'alimentation principale 70 au moyen de ponts de résistances. Pour simplifier la description et les figures, elles sont représentées sous forme de sources de tension indépendantes.

Le sous-ensemble de transmission 60, comportant une borne d'entrée 61 connectée à la borne d'entrée 57 du dispositif, et une borne de sortie 59 connectée à la borne d'entrée de l'amplificateur 42, est réalisé selon ce mode de réalisation de la façon suivante. Un inverseur 83 a sa borne d'entrée connectée à la borne 61, et sa borne de sortie connectée à une première entrée d'un additionneur 84, dont la sortie est connectée à la borne 59, et dont la deuxième entrée est connectée à la masse par l'intermédiaire d'une résistance 85. Une résistance 86 est connectée entre la seconde entrée de l'additionneur 84 et une borne d'entrée 87 du sous-ensemble de transmission 60. La borne d'entrée 87 est connectée à la borne de sortie 45 de l'amplificateur 41. Le pont de résistances 85-86 est un diviseur de tension. La valeur des résistances 85 et 86 est choisie de façon à ce que la tension de sortie de l'amplificateur 41 soit divisée, pour être appliquée à l'entrée de l'additionneur 84, par un facteur G, G étant le gain de l'amplificateur 41.

Le fonctionnement du dispositif est le suivant :

Supposons dans un premier temps que le signal appliqué sur la borne d'entrée 57 du dispositif amplificateur est faible, c'est-à-dire inférieur au seuil provoquant la saturation de l'amplificateur 41. Le signal, appliqué sur les deux entrées des comparateurs 77 et 79, est tel que la sortie de ces deux comparateurs est au niveau logique zéro. La sortie de la porte OU 81 est donc également au niveau logique zéro. Le dispositif amplificateur 82 fournit alors sur ses bornes de sortie 74 et 75 des tensions de commande telles que le transistor à effet de champ 72 soit conducteur et le transistor à effet de champ 73 soit bloqué. Ainsi, la charge 47 se trouve connectée entre la borne 53 de potentiel zéro et la borne de sortie de l'amplificateur 41. Cet amplificateur fournit le courant nécessaire à la charge et amplifie la tension du signal d'entrée présent à la borne 57. L'amplificateur 42, dont la sortie est en série avec le transistor à effet de champ 73 bloqué, ne débite aucun courant.

Lorsque le signal, partant d'une valeur positive faible, augmente, il atteint le seuil de saturation de l'amplificateur 41. A cet instant, le comparateur 77 change d'état, sa sortie passant au niveau logique 1, ce qui provoque l'apparition d'un niveau logique 1 à la sortie de la porte 81. Le dispositif 82 produit alors sur ses bornes de sortie 74 et 75 des tensions telles que le transistor MOS 72 se bloque, et le transistor 73 est conducteur. Dans ces conditions, la charge 47 se trouve connectée entre la borne de sortie de l'amplificateur 41 en état de saturation, et la borne de sortie de l'amplificateur 42. Le diviseur de tension formé par les résistances 85 et 86 fournit alors sur la borne d'entrée de l'additionneur 84 une tension égale à la tension de seuil de saturation de l'amplificateur 41 avec un signe convenable. Cette tension, additionnée à l'opposé du signal d'entrée de la borne 57, produit par l'inverseur 83, fournit à la borne 59 une tension dont le module est égal à la partie du signal d'entrée qui n'est pas amplifiée par l'amplificateur 41 en état de saturation, et de signe opposé. L'amplificateur 42 fournit ainsi sur sa borne de sortie une tension complémentaire de la tension fournie par l'amplificateur 41, ceci à condition qu'il ait le même gain G.

Dans le cas où le signal d'entrée devient négatif et supérieur en valeur absolue au seuil de saturation de l'amplificateur 41, la sortie du comparateur 77 reste à l'état logique 0, mais la sortie du comparateur 79 passe à un niveau logique 1, ce qui fait apparaître un niveau logique 1 à la sortie de la porte 81, provoquant, de même que précédemment, le blocage du transistor 72 et la conduction du transistor 73. Le fonctionnement est alors le même que dans le cas d'un signal positif supérieur au seuil de saturation.

Ce mode de réalisation, décrit en relation avec la figure 5, est susceptible de variantes. Par exemple, si l'amplificateur 42 présente une forte impédance de sortie lorsqu'il n'est pas commandé, il est alors possible de supprimer le transistor à effet de champ MOS 73. Pour cela, il suffit de prévoir en série avec l'entrée de cet amplificateur 42 un dispositif interrupteur pour déconnecter cette entrée lorsque l'amplificateur 42 ne doit pas être utilisé, c'est-à-dire lorsque le signal d'entrée à la borne 57 est faible. Notamment, on pourra prévoir de placer un transistor à effet de champ tel que 73 non plus à la sortie de l'amplificateur 42 mais en série avec son entrée.

Le transistor 73 pourra alors être un transistor à effet de champ de faible puissance.

Une autre variante de ce mode de réalisation consiste à connecter la borne d'entrée 76 du sous-ensemble de commande 55 non plus à la borne d'entrée 57 mais à la borne de sortie 45 de l'amplificateur 41. Dans ces conditions, pour obtenir le même fonctionnement, il suffit de prévoir des sources de tension 78 et 80 dont la valeur est voisine de la tension que présente la sortie 45 de l'amplificateur 41 lorsqu'il est saturé.

Dans ce qui précède, on a supposé que les deux amplificateurs 41 et 42 ont le même gain G et sont alimentés par une tension d'alimentation identique. Dans ces conditions, si S est la valeur maximale du signal d'entrée présent à la borne 57, la commutation de l'amplificateur 42 se produit au moment où le signal d'entrée atteint la moitié de sa valeur maximale, c'est-à-dire S/2. Il est possible de prévoir un dispositif pour lequel la commutation se produit pour une valeur différente de ce signal d'entrée. Pour cela, on peut prévoir un dispositif comportant deux sources d'alimentation, une première source telle que 70 alimentant l'amplificateur 41, de tension égale à 2 V, et une seconde source d'alimentation de tension 2 V' alimentant l'amplificateur 42. La première source 70 a, comme dans les modes de réalisation précédents, des potentiels sur ses deux bornes de sortie qui sont symétriques par rapport au potentiel de la borne 53 de potentiel zéro. De même, il faut que la seconde source de potentiel 2 V' ait ses deux bornes de sortie à des potentiels symétriques par rapport à la même borne de potentiel zéro. Ceci peut être réalisé par tout moyen bien connu dans la technique. La tension sur la charge 47 sera alors comprise entre + (V + V') et − (V + V'). Dans le cas où, par exemple, V' est égal au double de V, la commutation de l'amplificateur 42 se produira lorsque le signal d'entrée sur la borne 57 est égal au tiers de sa valeur maximale admissible. Une telle disposition peut avoir un intérêt si le signal d'entrée à amplifier est presque toujours inférieur au tiers de sa valeur maximale.

**Revendications**

1. Dispositif amplificateur pour audio-fréquences, comprenant un premier (41) et un second (42) amplificateur, le premier amplificateur étant alimenté par une source d'alimentation de tension dont les deux bornes de sortie sont à des potentiels symétriques par rapport à une borne (53) de potentiel zéro, ledit dispositif amplificateur débitant sur une charge (47) comportant des première (56) et seconde (48) bornes, la première borne (56) étant reliée à la borne de sortie (45) du premier amplificateur (41), le second amplificateur (42) étant alimenté par une tension d'alimentation dont les bornes sont à des potentiels symétriques par rapport à la borne de potentiel zéro (53), ce dispositif comprenant aussi des moyens de commutation (50) à deux états et des moyens de commande (55) pour forcer les moyens de commutation (50) dans l'un ou l'autre de leurs états suivant le niveau du signal à amplifier par le dispositif amplificateur, caractérisé en ce que les moyens de commutation (50) connectent dans le premier état la deuxième borne (48) de la charge à la borne de sortie (46) du second amplificateur et dans le deuxième état la deuxième borne (48) de la charge à la borne de potentiel zéro (53), et en ce qu'il comprend en outre des moyens de transmission (60) pour appliquer au second amplificateur (42) un signal d'entrée fonction du signal à amplifier dès que ce signal a atteint et dépassé un niveau amenant le premier amplificateur à la saturation.

2. Dispositif selon la revendication 1, caractérisé en ce que le second amplificateur est alimenté par la même source de tension VI que le premier amplificateur (41), les premier et second amplificateurs (41), (42) ayant le même gain.

3. Dispositif selon l'une des revendications 1 ou 2, caractérisé en ce que la borne de potentiel zéro (53) est connectée au point de liaison de deux sources de tensions égales (43, 44) connectées en série pour former la source d'alimentation de tension.

4. Dispositif selon l'une des revendications 1 ou 2, caractérisé en ce que la borne de potentiel zéro (53) est connectée au moyen d'un condensateur (71) à une borne de la source d'alimentation.

5. Dispositif selon l'une quelconque des revendications 1 à 4, caractérisé en ce que les moyens de commande (55) comprennent un premier comparateur (77) comparant le signal d'entrée à amplifier et une première tension positive (78) correspondant à la tension de seuil de saturation positive du premier amplificateur (41), un second comparateur (79) comparant le même signal d'entrée et une tension négative correspondant à la tension de seuil de saturation négative du premier amplificateur (41), les sorties des deux comparateurs (78), (79) étant connectées à une porte logique OU (81) commandant les moyens de commutation (50) par l'intermédiaire d'un moyen d'amplification (82) de façon que la deuxième borne de la charge (48) soit connectée à la borne de potentiel zéro (53) lorsque le signal d'entrée ne sature pas le premier amplificateur (41), et qu'elle soit connectée à la borne de sortie du second amplificateur (42) lorsque le signal d'entrée sature le premier amplificateur.

6. Dispositif selon l'une quelconque des revendications 1 à 5, caractérisé en ce que les moyens de transmission (60) comprennent un inverseur (83) fournissant l'opposé du signal à amplifier, un diviseur (85, 86) fournissant une fraction de la tension de sortie du premier amplificateur (41), et un additionneur (84) dont les bornes d'entrée sont connectées aux bornes de sortie de l'inverseur et du diviseur, fournissant sur l'entrée du second amplificateur (42) une tension égale et de signe opposé à la portion du signal d'entrée qui n'est pas amplifiée par le premier amplificateur.

7. Dispositif selon l'une quelconque des revendications 1 à 6, caractérisé en ce que les moyens de commutation (50) comprennent au moins un transistor à effet de champ (72, 73) dont le drain ou la source est connecté à la seconde borne de la charge (48), dont la source ou le drain est connecté à la borne de potentiel zéro, (53) et dont la grille est commandée par les moyens de commande (55), de telle sorte que le transistor soit saturé lorsque le signal à amplifier est faible.

8. Procédé d'amplification d'un signal électrique audio-fréquence au moyen de deux amplificateurs (41), (42) alimentés par des sources d'alimentation dont les bornes de sortie ont des potentiels symétriques par rapport à une borne de potentiel zéro (53), le premier amplificateur (41) étant connecté à l'une des bornes de la charge, caractérisé en ce qu'il consiste à connecter une seconde borne de la charge à la borne de potentiel zéro (53) lorsque le premier amplificateur (41) n'est pas saturé, et à connecter cette seconde borne de la charge à la sortie du second amplificateur (42), le second amplificateur (42), amplifiant la partie du signal qui n'est pas amplifiée par le premier amplificateur en état de saturation.

## Claims

1. Amplification device for audio-frequencies, comprising a first (41) and a second (42) amplifier, the first amplifier being fed by a voltage source, the two output terminals of which have symmetrical voltages with respect to one zero voltage terminal (53), the second amplification device being connected as the supply of a load (47), having first (56) and second (48) terminals, the first terminal (56) being connected to the output terminal (45) of the first amplifier (41), the second amplifier (42) being fed by a supply voltage, the terminals of which have symmetrical voltages with respect to the zero voltage terminal (53), this device also comprising two-state commutation means and control means (55) to force the commutation means (50) into one or other of their states according to the level of the signal to be amplified by the amplifier device, characterized in that the commutation means (50) connect in the first state the second terminal (48) of the load to the output terminal (46) of the second amplifier and in the second state the second terminal (48) of the load to the zero voltage terminal (53), and in that it comprises, furthermore, transmission means (60) to apply to the second amplifier (42) an input signal a function of the signal to be amplified once this signal has reached and exceeds a level leading the first amplification to saturation.

2. Device according to claim 1, characterized in that the second amplifier is fed by the same voltage source VI as the first amplifier (41), the first and second amplifiers (41, 42) having the same gain.

3. Device according to one of claims 1 or 2, characterized in that the zero voltage terminal (53) is connected to a linking point of two equal voltage sources (43, 44) connected in series to form the voltage source.

4. Device according to one of claims 1 and 2, characterized in that the zero voltage terminal (53) is connected by means of a capacitor (71) to a voltage source terminal.

5. Device according to one of claims 1 to 4, characterized in that the control means (55) comprise a first comparator (77) comparing the input signal to be amplified and a first positive voltage (78) corresponding to the threshold voltage of positive saturation of the first amplifier (41), a second comparator (79) comparing the same input signal and a negative voltage corresponding to the threshold voltage of negative saturation of the first amplifier (41), the outputs of the two comparators (78, 79) being connected to one OR gate (81) controlling commutation means (50) through the intermediary of an amplification means (82) so that the second terminal of the load (48) is connected to the zero voltage terminal (53) when the input signal does not saturate the first amplifier (41) and that it is connected to the output terminal of the second amplifier (42) when the input signal saturates the first amplifier.

6. Device according to one of claims 1 to 5, characterized in that the transmission means (60) comprise an inverter (83) supplying the opposite of the signal to be amplified, a divider (85, 86) supplying a fraction of the output voltage of the first amplifier (41), and an adder (84), the input terminals of which are connected to the output terminals of the inverter and divider, supplying on the input of the second amplifier (42) a voltage which is equal and opposite to the portion of the input signal that is not amplified by the first amplifier.

7. Device according to any one of claims 1 to 6, characterized in that commutation means (50) comprise at least one field-effect transistor (72, 73) the drain or the source of which is connected to the second terminal of the load (48), the source or drain of which is connected to the zero voltage terminal (53) and the grid of which is saturated when the signal to be amplified is weak.

8. Process for amplifying an electric audio-frequency signal by means of two amplifiers (41, 42) fed by current supplies, the output terminals of which have symmetrical voltages with respect to a zero voltage terminal (53), the first amplifier (41) being connected to one of the load terminals, characterized in that it consist in connecting a second load terminal to the zero voltage terminal (53) when the first amplifier (41) is not saturated, and in connecting this second load terminal to the output of the second amplifier (42) which amplifies the part of the signal that is not amplified by the first amplifier in a state of saturation.

**Ansprüche**

1. Verstärkervorrichtung für Audiofrequenzen, die einen ersten (41) und einen zweiten (42) Verstärker enthält, worin der erste Verstärker durch eine Speisespannungsquelle versorgt wird, deren zwei Ausgangsklemmen in Bezug auf eine Klemme (53) mit Nullpotential gleichmässige Potentiale haben, worin die besagte Verstärkervorrichtung einen Verbraucher (47) speist der eine erste (56) und eine zweite (48) Klemme enthält, dabei die erste Klemme (56) mit der Ausgangsklemme (45) des ersten Verstärkers (41) verbunden ist, der zweite Verstärker (42) durch eine Versorgungsspannung, deren Klemmen in Bezug auf die Klemme mit Nullpotential (53) gleichmässige Potential haben, versorgt wird, worin diese Vorrichtung auch Kommutationsmittel (50) mit zwei Zuständen enthält und Steuermittel (55) enthält um die Kommutationsmittel (50) in den einen oder anderen ihrer Zustände zu bringen, je nach dem Niveau des durch die Verstärkungsvorrichtung zu verstärkenden Signals, dadurch gekennzeichnet, dass die Kommutationsmittel (50) im ersten Zustand die zweite Klemme (48) des Verbrauchers mit der Ausgangsklemme (46) der zweiten Verstärkers verbinden und im zweiten Zustand die zweite Klemme (48) des Verbrauchers mit der Klemme des Nullpotentials (53) verbinden und dadurch dass, sie des weiteren Transmissionsmittel (60) enthält um bei dem zweiten Verstärker (42) ein von dem zu verstärkenden Signal abhängendes Eingangssignal anzubringen, sobald als dieses Signal ein den ersten Verstärker zur Sättigung führendes Niveau erreicht und überschritten hat.

2. Vorrichtung nach Ansprach 1, dadurch gekennzeichnet, dass der zweite Verstärker durch die selbe Spannungsquelle V1 wie der erste Verstärker (41) versorgt wird wobei, der erste und der zweite Verstärker (41), (42) denselben Verstärkungsfaktor haben.

3. Vorrichtung nach einem der Ansprüche 1 oder 2, dadurch gekennzeichnet dass, die Klemme des Nullpotential (53) an den Verbindungspunkt der zwei Quellen gleicher Spannung (43, 44) angeschlossen ist, welche in Reihe geschaltet sind um die Speisespannungsquelle zu bilden.

4. Vorrichtung nach einem der Ansprüche 1 oder 2, dadurch gekennzeichnet dass, die Klemme des Nullpotentials (53) mit Hilfe eines Kondensators (71) an eine Klemme der Versorgungsquelle angeschlossen ist.

5. Vorrichtung nach einem der Ansprüche 1 bis 4, dadurch gekennzeichnet dass, die Steuermittel (55) einen ersten Komparator (77) umfassen, der das zu verstärkende Eingangsignal und eine erste positive Spannung (78) vergleicht die der positiven Sältigungsgrenzspannung des ersten Verstärkers (41) entspricht (41), worin ein zweiter Komparator (79) dasselbe Eingangssignal und eine negativen Sättigungsgrenzspannung des ersten Verstärkers (41) entsprechende Spannung vergleicht, worin die Ausgänge der zwei Komparatoren (78, 79) mit einem ODER-Gatter (81) verbunden sind, welches die Kommutationsmittel (50) mit Hilfe eines Verstärkermittels (82) dergestalt steuert dass, die zweite Klemme des Verbrauchers (48) mit der Klemme des Nullpotentials (53) verbunden ist, wenn das Eingangssignal den ersten Verstärker (41) nicht sättigt, und dass sie mit der Ausgangsklemme des zweiten Verstärkers (42) verbunden ist, wenn das Eingangssignal den ersten Verstärker sättigt.

6. Vorrichtung nach einem der Ansprüche 1 bis 5, dadurch gekennzeichnet dass, die Transmissionsmittel (60) einen Umschalter (83) enthalten der das Gegenteil des zu verstärkenden Signals liefert, einen Teiler (85, 86) der einen Teil der Ausgangsspannung des ersten Verstärkers (41) liefert, und einen Addierer (84) enthalten, dessen Eingangsklemmen mit den Ausgangsklemmen des Umschalters und des Teilers verbunden sind und der am Eingang des zweiten Verstärkers (42) eine Spannung liefert, die gleich und mit umgekehrten Vorzeichen zu dem Teil der Eingangssignals ist der nicht durch den ersten Verstärker verstärkt wird.

7. Vorrichtung nach einem der Ansprüche 1 bis 6, dadurch gekennzeichnet dass, die Kommutationsmittel (50) mindestens einen Feldeffekttransistor (72, 73) enthalten, dessen Abzugskanal oder Quelle mit der zweiten Klemme des Verbrauchers (48) verbunden ist, dessen Quelle oder Abzugskanal mit der Klemme des Nullpotentials (53) verbunden ist und dessen Gitter durch die Steuermittel (55) dergestalt gesteuert wird, dass der Transistor gesättigt ist, wenn dass zu verstärkende Signal schwach ist.

8. Verstärkungsverfahren eines elektrischen Audiofrequenzsignals mit Hilfe von zwei Verstärkern (41, 42) die durch Spannungsversorgungsquellen versorgt werden, deren Ausgangsklemmen in Bezug auf eine Klemme mit Nullpotential (53) gleichmässige Potentiale haben, wobei der erste Verstärker (41) mit einer der Klemmen des Verbrauchers verbunden ist, dadurch gekennzeichnet, dass es in der Anschliessung einer zweiten Klemme des Verbrauchers an die Klemme des Nullpotentials (53) besteht, wenn der erste Verstärker (41) nicht gesättigt ist, und in der Anschliessung dieser zweiten Klemme des Verbrauchers an den Ausgang des zweiten Verstärkers (42), wobei der zweite Verstärker (42) den Teil des Signals verstärkt der, nicht durch den sich im Zustand der Sättigung befinlichen Verstärker verstärkt wird.

FIG_1

FIG_2

FIG. 3

FIG. 4

2

FIG - 5